# EUROPEAN PATENT APPLICATION

(11) **EP 2 202 789 A1**
(43) Date of publication of application: **30.06.2010**
(21) Application number: 08291239.5
(22) Date of filing: 24.12.2008
(51) Int. Cl.: H01L 21/98, H01L 25/10

(54) **Stack of molded integrated circuit dies with side surface contact tracks**

(71) Applicant: NXP B.V., 5656 AG Eindhoven (NL)
(72) Inventor: Pommier, Mickael, 1400 Caen (FR); Ledain, Sophie, 1400 Caen (FR); Rousseville, Lucie, 67700 Waldolwisheim (FR)
(74) Representative: Vignesoult, Serge L. M.

(57) **Abstract**

A method of forming electrical connections on an integrated circuit package, the method comprising: providing a cuboid-shaped stack (630) within which are moulded a plurality of integrated circuit dies, the stack having a lower face (650) with a plurality of electrical connections provided thereon; forming a plurality of tracks (730) along a side face (640) of the stack, each track surface (740) having a greater surface roughness than a surface (750) of the side face on either side of the track; and electroless metal plating the stack to deposit a metallic layer on each of the plurality of tracks to thereby electrically connect each of the integrated circuit dies to a selection of the electrical connections on the lower face of the stack.

## Description

The invention relates to forming electrical connections on integrated circuit packages, and in particular to methods of providing electroless metal plated connections on 3-dimensional stacks of integrated circuit packages.

Integrated circuits are most commonly manufactured by techniques that rely on successive 2-dimensional patterning processes, resulting in integrated circuit (IC) dies. The dies are packaged, typically in a mouldable composition such as an epoxy resin, to protect the sensitive components from external environments in use. This process results in integrated circuit chips having a largely planar construction. Stacking techniques may be used to increase the density of chips in a given volume, for example by stacking circuit boards on which the chips are mounted.

Further improvements in density can be provided by stacking the dies themselves in a 3-dimensional integrated circuit package, resulting in cuboid-shaped packages that can be compatible with existing surface mounting techniques such as BGA (Ball Grid Array) and LGA (Land Grid Array) connections. A problem with such packages, however, is that of being able to redistribute electrical connections to the IC dies in successive layers of the package. For reasons of economies of scale, each stack of dies is typically required to be cut from a stack of wafers each of which is made up of a 2-dimensional array of dies. This cutting process prevents electrical connections from being made between the dies to a base layer of the stack (e.g. for connection to a motherboard via a BGA) until after the stacks are divided from the stack of wafers. A method is therefore required to allow electrical connections to be made along one or more side faces of the stacks after division.

Advantages of forming 3-dimensional stacks of IC dies in a single package include the absence of the need for wire bonds and the capability of different die sizes to be stacked internally while retaining a similar outer appearance and electrical layout. The electrical layout of a stack can be routed via one or more side walls of the package. Although a 3-dimensional stack may add further cost to the overall packaging process, this can outweigh the alternative costs involved in stacking packages on circuit boards, as well as result in a substantial overall saving in total volume for a given function.

To form the required electrical layout on a 3-dimensional stack, a technique of applying electrical connection traces along the side faces of the stack is required. Various techniques may be possible, one of which is that of electroless metal plating, being a well-known technique for depositing conductive metallic coatings on non-conductive, as well as conductive, substrates. This plating technique can be used to apply electrical connections on a 3-dimensional stack by applying an overall metallic coating followed by a patterning technique such as laser patterning to form individual traces. Laser patterning is, however, problematic due to i) being expensive; ii) tending to result in peeling of the deposited metallic layer; and iii) penetration of the laser into the intermediate layers of the stack (e.g. glue or foil layers), causing defects.

It is an object of the invention to address one or more of the above mentioned problems, to provide an electrical routing solution for a 3-dimensional stack of IC dies in a single package.

According to a first aspect of the invention there is provided a method of forming electrical connections on an integrated circuit package, the method comprising:
providing a cuboid-shaped stack within which is moulded a plurality of integrated circuit dies, the stack having a lower face with a plurality of electrical connections provided thereon;
forming a plurality of tracks along a side face of the stack, each track having a greater surface roughness that a surface of the side face on either side of the track; and
electroless metal plating the stack to deposit a metallic layer on each of the plurality of tracks to thereby electrically connect each of the integrated circuit dies to a selection of the electrical connections on the lower face of the stack.

By forming roughened tracks on the side wall(s) of the stack, an electroless metal plating process can be used to selectively deposit metal tracks only where required, i.e. to make appropriate connections on the edge of each layer of the stack. Other surface portions of the stack having a smoother surface are not subjected to metal plating.

According to a second aspect of the invention there is provided an integrated circuit package comprising a cuboid-shaped stack within which are moulded a plurality of integrated circuit dies, the stack having a lower face with a plurality of electrical connections provided thereon, a plurality of tracks being provided along a side face of the stack, each track having a greater surface roughness than a surface of the side face either side of the track, each track having a metallic layer deposited thereon electrically connecting one or more of the integrated circuit dies to an electrical connection on the lower face of the stack.

The invention will now be described by way of example with reference to the appended drawings in which:
figures 1a to 1d illustrate in schematic cross-section a process for providing a wafer comprising an array of semiconductor dies;
figure 2 is a plan view of an exemplary wafer resulting from the process of figures 1a to 1 d;
figures 3a and 3b are schematic cross-sectional and plan views of a portion of a wafer comprising an array of dies;
figure 4a is a schematic cross-sectional view of a wafer having electrical fan-out connections;
figure 4b is a schematic cross-sectional view of the wafer of figure 4a upon separation from a support substrate;
figures 5a to 5d are schematic cross-sectional views illustrating a process of building up a stack of wafers;
figure 6 is a schematic cross-sectional view of a stack of wafers after division into individual stacks;
figures 7a to 7c illustrate in schematic perspective views an exemplary process of providing roughened tracks along side faces of a stack;
figure 7d is a schematic cross-sectional view of a roughened track resulting from the process of figures 7a-c, in the form of a sawn groove;
figure 8 is a schematic cross-sectional view of a plurality of stacks after an electroless metal deposition process;
figure 9a is a schematic cross-sectional view of the roughened track of figure 7d after the electroless metal deposition process;
figure 9b is a schematic perspective view of a stack after the electroless metal deposition process; and
figure 10 is a schematic cross-sectional view of a stack mounted on a PCB.

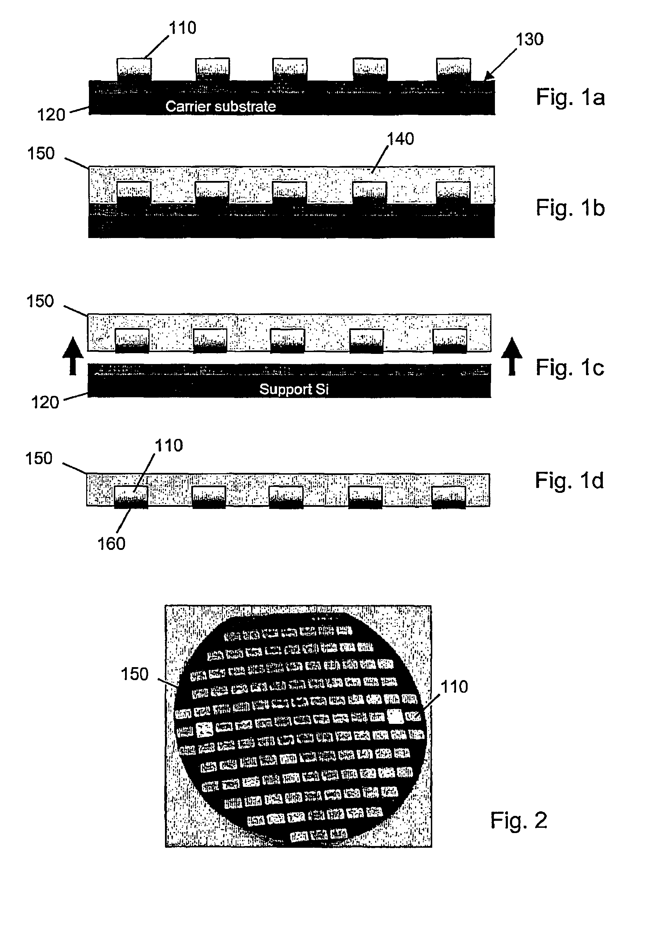

Figures 1 a to 1 d illustrate an exemplary process for obtaining a wafer-scale chip package. As shown in figure 1a, in a first step individual semiconductor dies (or chips) 110 are placed on a carrier substrate 120, the chips being attached to the carrier substrate 120 by means of an temporary bonding layer, for example in the form of a double-side adhesive tape 130. Preferably each die is tested before being placed on the carrier substrate 120, so that only functioning dies are used.

In a second step, shown in figure 1b, the dies 110 are moulded into a wafer 150 by applying a moulding compound 140 around the dies. The underside of each die 110, on which electrical connections are to be made, is protected from the moulding compound 140 by being attached to the carrier substrate 120.

In a third step, shown in figure 1c, the wafer 150 is separated from the carrier substrate 120. The wafer 150, with electrical connections on the exposed surfaces 160 of the now embedded dies 110 (figure 1d), can then be handled as a single unit during subsequent processing steps. A plan view of an exemplary wafer 150, in which a 2-dimensional array of dies 110 is embedded, is shown in figure 2.

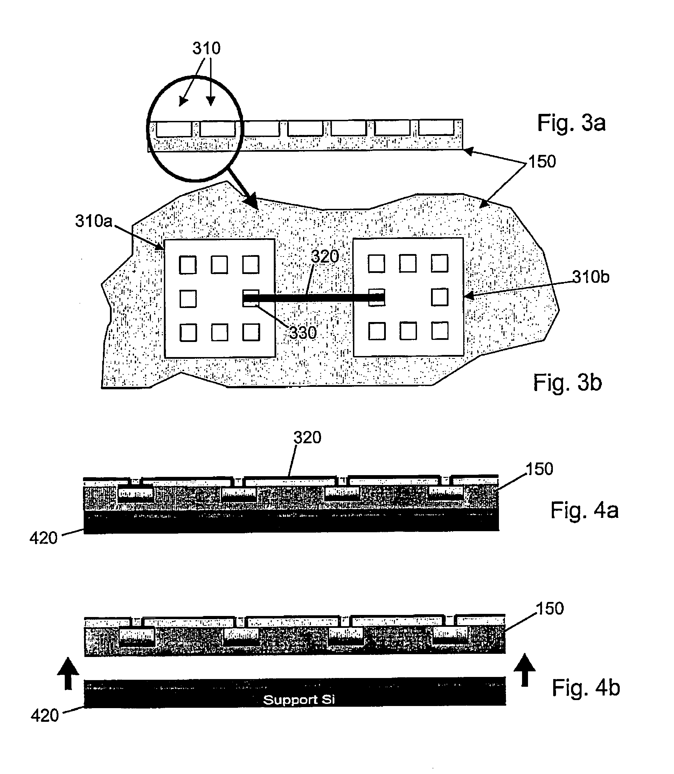

Figures 3a and 3b illustrate schematically a subsequent step performed on each wafer, which provides fan-out electrical connection traces from each die 110. Electrical connections between adjacent dies 310a, 310b are deposited on a surface of the wafer 150, one such connection 320 being shown in figure 3b. Each connection 320 connects a die pad 330 of one die 310a to that of another die 310b. These connections 320 are also shown in cross-section in figure 4a, which illustrates the wafer 150 now attached to a carrier substrate 420 with the exposed surfaces on the dies 310 face-up to allow the connections 320 to be applied. The wafer 150 is then separated from the carrier substrate 420 after the connections are applied (figure 4b).

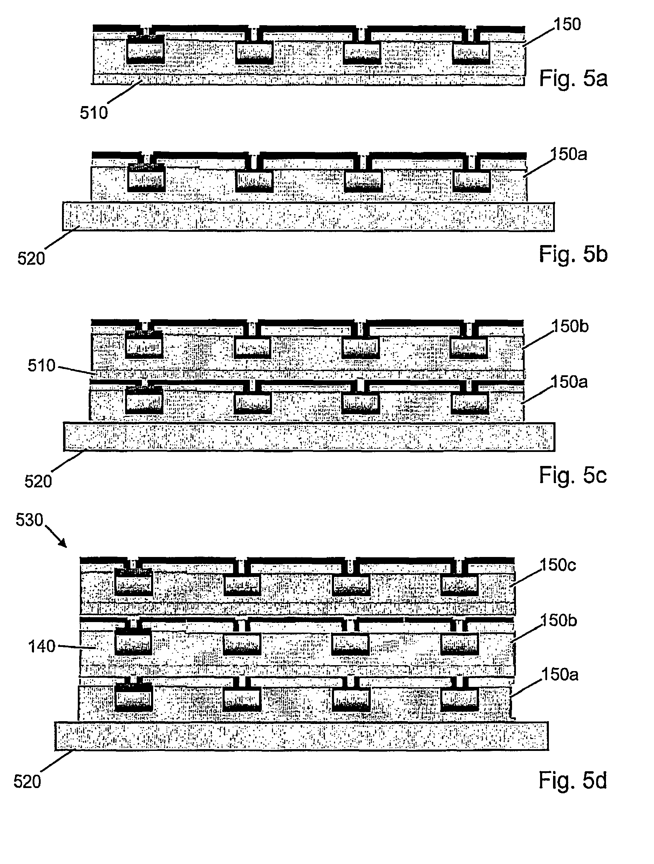

Figures 5a to 5d illustrate further processing stages involved in creating a 3-dimensional stack of wafers. Shown in figure 5a, a glue layer 510 is applied to a face of each wafer 150. A first wafer 150a is attached to a carrier substrate 520 (figure 5b). A second wafer 150b is then attached to the first wafer 150a with the glue layer 510 (figure 5c). The process is repeated (figure 5d) until sufficient layers have been assembled. A 3-dimensional stack 530 is then formed in which each layer 150a, 150b, 150c comprises a 2-dimensional array of dies that are electrically connected within the plane of the layer but the layers are electrically isolated from each other by the compound moulding material 140 and glue layers 510.

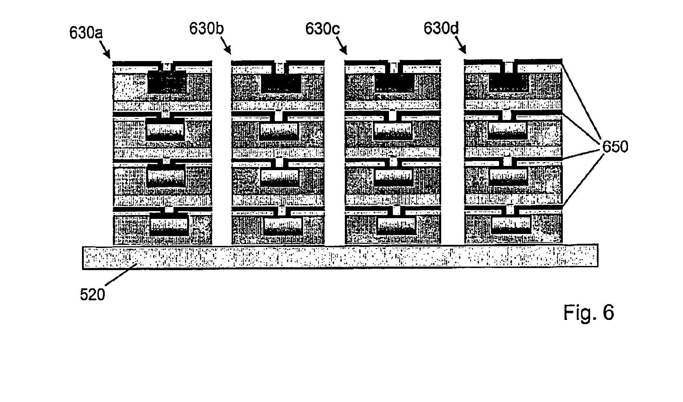

As shown in figure 6, the 3-dimensional stack 530, in this case comprising four wafer layers, is then divided into individual stacks 630a-d in a machining operation. The machining operation preferably comprises a series of sawing operations, for example using a computer-controlled grinding disc to accurately saw through the wafers between adjacent dies. This machining operation exposes electrical connections 640 on side faces of each of the stacks 630a-d. The individual stacks 630a-d can then be removed from the carrier substrate 520.

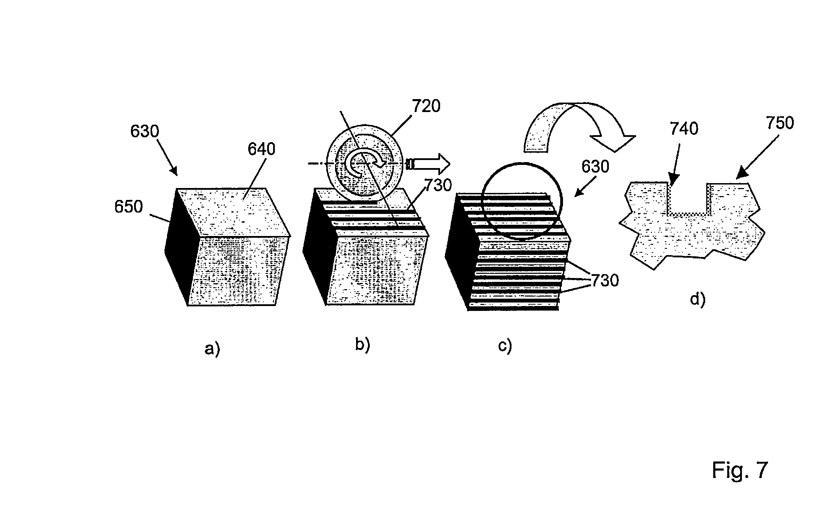

Figures 7a to 7c illustrate schematically a series of steps of an exemplary process of forming roughened tracks on a stack prior to an electroless metal deposition process. Figure 7a shows an individual stack 630 after division from the stack of wafers described above. The stack 630 has a lower face 650 on which electrical connections (not shown) are to be made, for example by means of a ball grid array. The stack 630 has four side faces 640 on which side routing electrical traces are to be applied, in order to connect a redistribution layer on the lower face 650 with each layer in the stack 630, thereby allowing each of the dies embedded in the stack 630 to be electrically connected to via the lower face 650 of the stack 630.

As shown in figure 7b, a sawing blade 720 is applied to the side face 640 of the stack 630. The sawing blade 720 is preferably in the form of a circular disc having a cutting surface provided by a composite of hard cutting particles (e.g. diamond) in a softer supporting matrix (e.g. metal). The sawing blade 720 is selected to have a size range of cutting particles larger than that of the blade used to divide the stacks from the wafer stack in the preceding division process. This results in the surface left behind after machining with the sawing blade 720 being rougher than the surrounding surface formed by division of the stacks.

Figure 7c shows the stack after the selective sawing process is complete, with a plurality of grooves 730 being formed along each side face of the stack 630. The cross-sectional form of a typical groove is illustrated further in figure 7d. The surface 740 of the groove, as created by the sawing blade 720, is rougher than the surrounding surface 750, as created by the stack division process.

The stack 630 is then subjected to an electroless metal plating process, to deposit a metallic layer 710 over at least one side wall 640 of the stack 630. Because the tracks created by the machining process described above are rougher than the surrounding surface of the side wall, the metal plating process will preferentially deposit a metallic layer on these tracks. A minimum required surface roughness for deposition of a metal layer by electroless plating has been determined to be around 2.5µm, and preferably greater than 4µm. It has been evaluated that a roughness of 4µm is typically necessary to obtain adequate adhesion of a NiAu layer on a surface. If a surface roughness is below this level there is typically no adhesion. The sawing blade 720 is therefore chosen so that the grooves left behind have at least this level of surface roughness. A typical roughness left behind by the singulation process (cutting the individual stacks from a wafer stack) is around 1µm (+/- 0.5µm), which is sufficiently low to avoid metal being deposited on the surfaces not roughened by the subsequent sawing process. The upper and lower surfaces of the stack do not therefore need any protection from the electroless plating process, provided the non-metallic parts of these surfaces have a surface roughness below the minimum value for deposition of such a coating. Surface roughness values may be characterised according to the arithmetic average of absolute values of a surface, commonly identified as the *Rₐ* value of the surface.

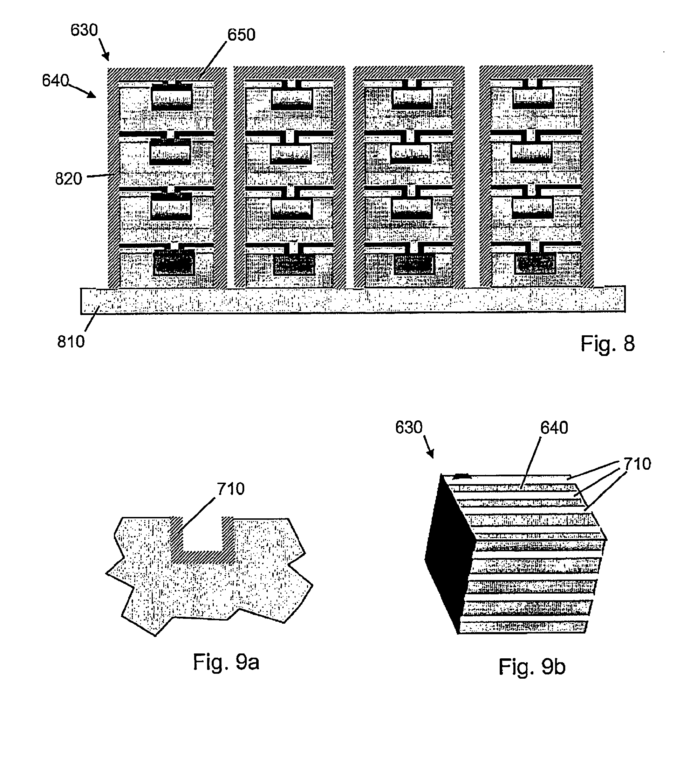

Figure 8 illustrates a plurality of stacks 630 after the electroless metal deposition process, the stacks 630 being mounted on a carrier substrate for carrying out the process of metal deposition. Metal layers 820 are deposited on each side wall 640 of the stacks 630, as well as along the lower face 650 of the stacks to build up the electrical connections provided thereon.

A particular preferred material for use as the deposited metal layer is a nickel and gold composition (Ni-Au). Various processes for electroless metal deposition are known in the art, and need not be described here in detail. Further information regarding an exemplary electroless Ni plating process suitable for use with the invention is disclosed by W. Riedel in "Electroless Nickel Plating", ASM International, 1991. However, the inventors have recognised that surface roughness, at least for electroless metal deposition on non-conducting surfaces, is a key factor in allowing such metal layers to be deposited.

Figure 9a shows in cross-section the approximate form of a conductive track 710 formed by electroless metal deposition in a groove machined into a side face of a stack. Figure 9b illustrates the form of the tracks 710 aligned along the side faces 640 of the stack 630.

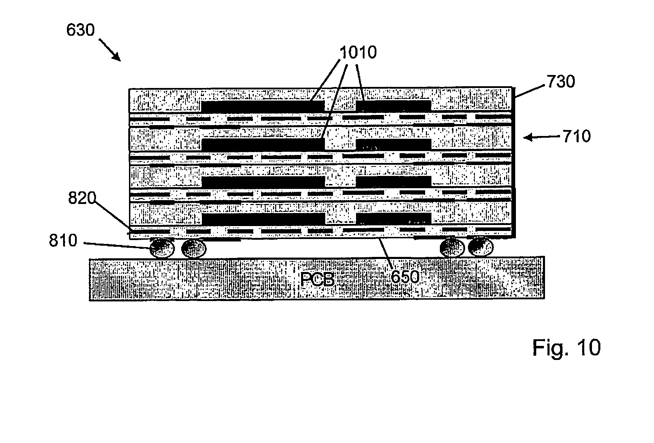

After the tracks are deposited, the stack is ready for being mounted on to a PCB, as shown in figure 10. The lower face 650 of the stack 630 is provided with a ball grid array 810, which connects to a redistribution layer 820 on the lower face 650 of the stack 630. Connections are made between the redistribution layer 820 and other dies 1010 in the stack 630 via conductive tracks 710 in the side wall(s) 640 of the stack 630.

An advantage of the above described method of applying conductive tracks on a side wall of the stack is that the selective sawing process creates grooves that serve to protect the deposited metal layers from being damaged during subsequent processing and handling. The grooves also provide additional surface area (on the side walls of each groove), increasing adhesion of the metal as well as reducing the resistance of the metal tracks, which improves the electrical connectivity and reliability of the stack.

Other embodiments are intentionally within the scope of the invention as defined by the appended claims.

## Claims

1. A method of forming electrical connections on an integrated circuit package, the method comprising:
providing a cuboid-shaped stack within which are moulded a plurality of integrated circuit dies, the stack having a lower face with a plurality of electrical connections provided thereon;
forming a plurality of tracks along a side face of the stack, each track having a greater surface roughness than a surface of the side face on either side of the track; and
electroless metal plating the stack to deposit a metallic layer on each of the plurality of tracks to thereby electrically connect each of the integrated circuit dies to a selection of the electrical connections on the lower face of the stack.

2. The method of claim 1 wherein each track is formed by sawing a groove along a side face of the stack, the groove extending between an upper face and the lower face of the stack.

3. The method of claim 1 or claim 2 comprising the preceding steps of:
providing a plurality of wafers, each wafer comprising a planar array of integrated circuit dies;
applying electrical connection traces to a first face of each wafer;
stacking the plurality of wafers to form a 3 dimensional array of integrated circuit dies; and
dividing the array into a plurality of said cuboid-shaped stacks by cutting the stack of wafers between adjacent integrated circuit dies.

4. The method of claim 1 wherein the average surface roughness of each track is at least 2.5µm.

5. The method of claim 1 or claim 4 wherein the average surface roughness of the surface of the side face on either side of each track is 1.5µm or less.

6. The method of claim 1 or claim 5 wherein the average surface roughness of each track is at least 4µm.

7. An integrated circuit package comprising a cuboid-shaped stack within which are moulded a plurality of integrated circuit dies, the stack having a lower face with a plurality of electrical connections provided thereon, a plurality of tracks being provided along a side face of the stack, each track having a greater surface roughness than a surface of the side face on either side of the track, each track having a metallic layer deposited thereon electrically connecting one or more of the integrated circuit dies to an electrical connection on the lower face of the stack.

8. The package of claim 7 wherein each track comprises a groove in the side face of the stack extending between an upper face and the lower face of the stack.

9. The package of claim 7 wherein the average surface roughness of each track is at least 2.5µm.

10. The package of claim 7 or claim 9 wherein the average surface roughness of the surface of the side face on either side of each track is 1.5µm or less.

11. The package of claim 7 or claim 10 wherein the average surface roughness of each track is at least 4 µm.
